# EUROPEAN PATENT APPLICATION

(11) **EP 0 987 763 A1**
(43) Date of publication of application: **22.03.2000**
(21) Application number: 98830535.5
(22) Date of filing: 15.09.1998
(51) Int. Cl.: H01L 27/07

(54) **Diode connected transistor and related process of fabrication**

(71) Applicant: STMicroelectronics S.r.l., 20041 Agrate Brianza (Milano) (IT)
(72) Inventor: Pio, Federico, 20047 Brugherio (Milano) (IT)
(74) Representative: Mittler, Enrico

(57) **Abstract**

Semiconductor device comprising a semiconductor layer (1) of a first type of conductivity, a gate oxide layer (4) superimposed to the semiconductor layer (1), at least one polysilicon region (11; 31) superimposed to the gate oxide layer (4), a first (13) and a second doped region (8,10; 13) of a second type of conductivity in the semiconductor layer (1). The first (13) and second doped region (8,10; 13) being spaced-apart in order to form a channel region therebetween, under the polysilicon layer (11; 31), and the first doped region (13) extends under a contact opening (14) obtained in the gate oxide layer (4) in correspondence of the polysilicon layer (11; 31), so that the polysilicon layer (11; 31) is electrically connected with the first doped region (13) through the contact opening (14).

## Description

The present invention concerns a diode connected transistor and a related process of fabrication. In particular, the invention relates to a diode connected transistor which does not require any metal contact for short-circuiting the drain electrode with the gate electrode.

In the electronic devices, it is often necessary to integrate transistors in a diode connection, that is with the gate electrode short-circuited with the drain electrode or with the source electrode.

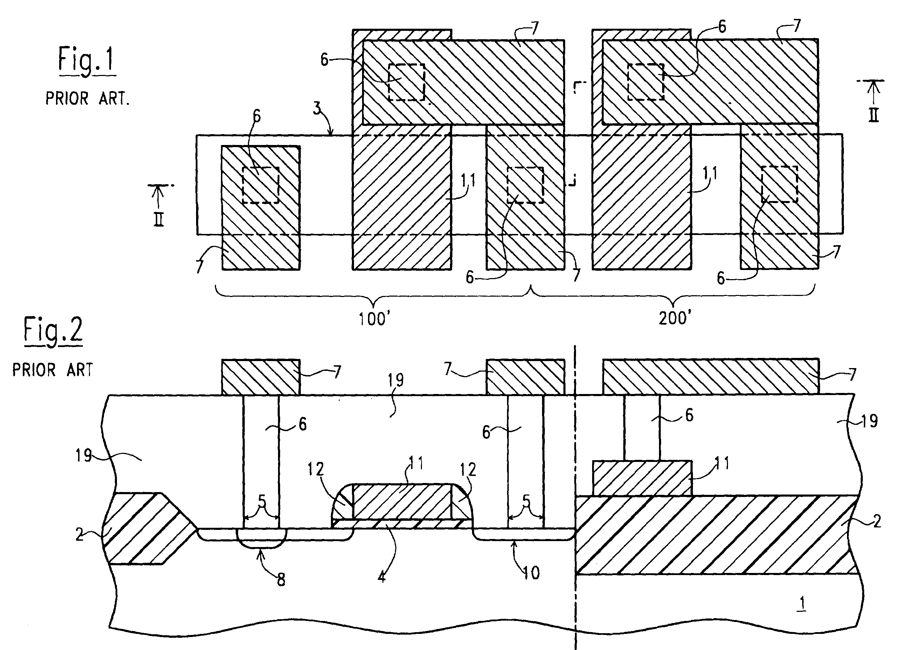

Figures 1 and 2 show, in a plant view and in a section view respectively, a typical diode connection of two MOS transistors 100' and 200', in order to form two diodes connected in series. Field oxide regions 2, which define an active area zone 3, are present over a layer of a semiconductor material 1.

Moreover, a thin gate oxide layer 4 and a superimposed layer of intermediate dielectric material 19 with openings 5 for metal connections are present over the semiconductor layer 1. A corresponding metal contact 6, also connected to metal lines 7, is provided on each opening 5.

Each opening 5 of the dielectric layer corresponds to a determined transistor region, in particular there is shown a source region 8 of the transistor 100', and to a region 10 that corresponds to a source region for the transistor 200' and to a drain region for the transistor 100'.

Polysilicon layers 11, corresponding to the gate electrodes of the transistors 100' and 200', are also shown, and spacers 12 are present at the sides of the above-mentioned polysilicon layers 11. The gate oxide layer 4 is present only under the polysilicon layers 11 and the spacers 12. Figure 1 does not show the oxide regions for a better showing of the figure itself.

As it can be noted, every polysilicon layer 11, corresponding to the gate electrode of the related transistor, is connected, in a typical diode connection, to the drain region of the transistor itself by means of contacts 6 and metal lines 7.

The implementation on silicon of structures constituted by diode connected transistors, in series or in parallel, can create problems of space utilization. Referring to the patent application EP 0 715 312 of the same inventor, wherein a circuit solution for accomplishing a multi-level program in an EEPROM memory, the utilization of diode connected transistors, substantially in a similar way to that shown in Figures 1 and 2, is expensive in terms of space utilization because the series and/or parallel connection of the different diode connected transistors have to observe the pitch of the memory cells, and moreover the metal connections between the gate electrode and the drain electrode of each diode connected transistor prevent from using that space for other interconnection lines, in some cases necessary in a so dense region.

Another problem can occur in the case in which the voltages applied to the transistor are high (as described, for example, in EP 0 715 312) and the manufacturing process provides for steps of salicidation of the active areas (for example for reducing the access resistance of the transistors in a speedy logic), because a diode connected transistor having a high breakdown voltage is difficult to fabricate.

During the salicidation process, in fact, the formation of the metal compound would eat away silicon, including the lightly doped source and drain junctions and so provoking a short-circuit between the corresponding electrode and the substrate; moreover, the metal compound would transfer the voltage up to the boundary zone between the active area and the field oxide, preventing from using the depletion regions of the lightly doped silicon.

In view of the state of the art described, it has been an object of the present invention to provide a diode connected transistor with a minimum number of metal interconnections, in order to reduce the structure dimensions and to solve the above-mentioned problems.

According to the present invention, such an object is achieved by means of a semiconductor device comprising a semiconductor layer of a first type of conductivity, a gate oxide layer superimposed to said semiconductor layer, at least one polysilicon region superimposed to said gate oxide layer, a first and a second doped region of a second type of conductivity in said semiconductor layer, said first and second doped region being spaced-apart in order to form a channel region therebetween, under said polysilicon layer, characterized in that said first doped region extends under a contact opening obtained in said gate oxide layer in correspondence of said polysilicon layer, so that said polysilicon layer is electrically connected with said first doped region through said contact opening.

The features and advantages of the present invention will be made clearer by the following detailed description of four embodiments thereof, illustrated as non-limiting examples in the annexed drawings, wherein:
Fig. 1 shows a plant view of two diode connected transistors according to the prior art;
Fig. 2 shows a cross-sectional view taken along line II-II of Figure 1;
Fig. 3 shows a plant view of two diode connected transistors according to a first embodiment of the present invention;
Fig. 4 shows a cross-sectional view taken along line IV-IV of Figure 3;
Fig. 5 shows a plant view of two diode connected transistors according to a second embodiment of the present invention;
Fig. 6 shows a cross-sectional view taken along line VI-VI of Figure 5;
Fig. 7 shows a plant view of two diode connected transistors according to a third embodiment of the present invention;
Fig. 8 shows a cross-sectional view taken along line VIII-VIII of Figure 7;
Fig. 9 shows a plant view of two diode connected transistors according to a fourth embodiment of the present invention;
Fig. 10 shows a cross-sectional view taken along line X-X of Figure 9;
Figs. 11A to 11J schematically show the main steps of a manufacturing process of two diode connected transistors, according to the first embodiment of the present invention;
Fig. 12 shows a section view of two diode connected transistors each having two polysilicon layers, according to the first embodiment of the present invention.

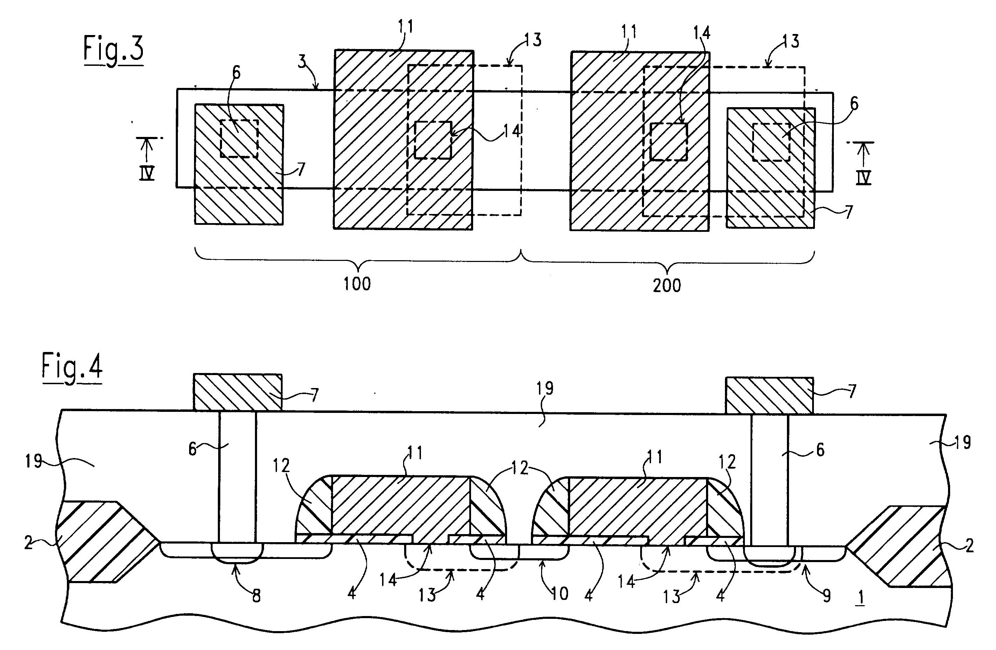

Figures 3 and 4 show, in a plant view and in a section view respectively, two diode connected transistors 100 and 200 according to a first embodiment of the present invention. In particular, the two diode connected transistors are connected in series.

The connections between the polysilicon layers 11, corresponding to the gate electrodes, and the related drain electrodes (for the transistor 200 the drain region is the region 9, whereas for the transistor 100 the drain region is the region 10) are made possible by means of diffusion regions 13 and direct contact regions 14, instead of contacts 6 and metal stripes 7 as in prior art.

The diffusion regions 13 are obtained during initial steps of the manufacturing process by means of a N+ implantation (for example if the diode connected transistors are integrated in an EEPROM memory, it is possible to use the N+ implantation under the tunnel oxide of the memory cells), and they extend up to the drain junctions 9 and 10 of the transistors. The diffusion regions 13 are connected to the polysilicon layers 11 by means of direct contact regions 14 obtained in the thin gate oxide layer 4.

Such a structure allows a high reduction of the occupied space and, obviously, that reduction is proportional to the number of the present transistors. With this structure, in fact, a reduction of the gate-contact distance (multiplied by two), of the overall dimensions of the contact itself, and furthermore of all the space necessary to form the contact with the gate over the field oxide, is obtained. It is evident that in the case of diode connected P channel transistors, the conductivity types of the doped regions have to be exchanged.

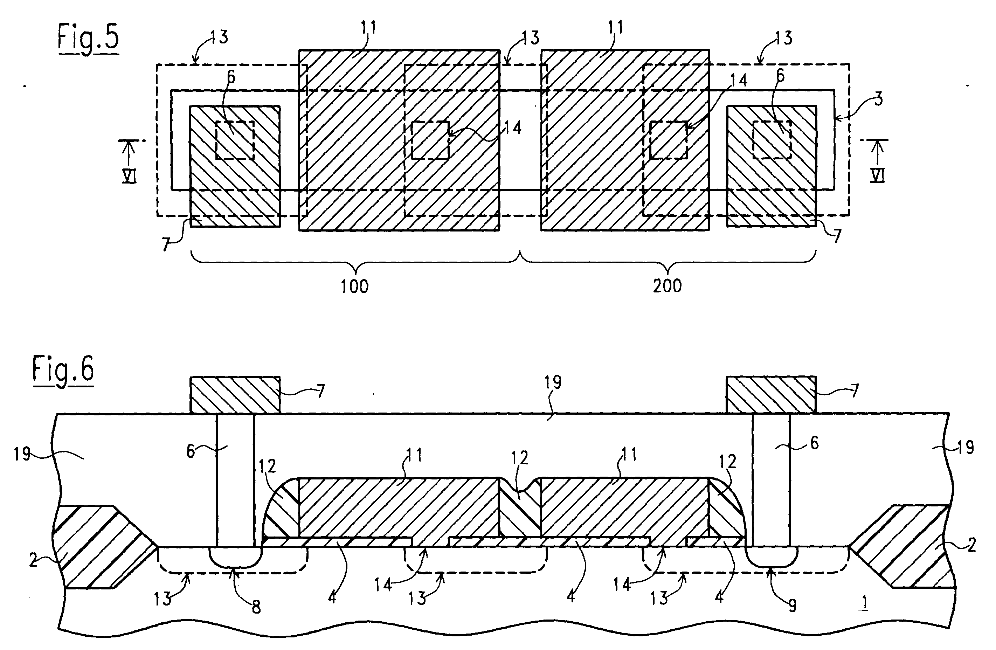

Figures 5 and 6, similar to Figures 3 and 4 respectively, show a second embodiment of the present invention. In this case the distance between the two polysilicon layers, i.e. between the two gates, of the two transistors connected in series, is reduced to a minimum that can be lithographically obtained. Such a distance can reach, by means of the actual lithographic techniques in use, an extension smaller than the lateral dimension of the spacer 12 that is usually formed on the sidewalls of the polysilicon layer 11.

Then, the spacers between two adjacent transistors can be undistinguishable and so it is possible to avoid source/drain implantations in the underlying region due to the shielding effect caused by the dielectric layer 12 that constitutes the spacers themselves.

In order to guarantee an electrical connection between the drain diffusion 9 of the transistor 200 and the related gate region 11, it is necessary to make a proper N+ implantation at the beginning of the process (for example the N+ implantation made under the tunnel oxide of the EEPROM memory cells), so that a sufficiently extended diffusion region 13 is formed.

Such a solution turns out to be particularly advantageous even when a salicidation step of the active areas is provided (for example to reduce their resistance), because the diffusion region 13 resulting from the N+ implantation is usually deep enough to avoid a complete consumption of dopant during the reaction between metal and silicon (therefore avoiding a short-circuit with the substrate).

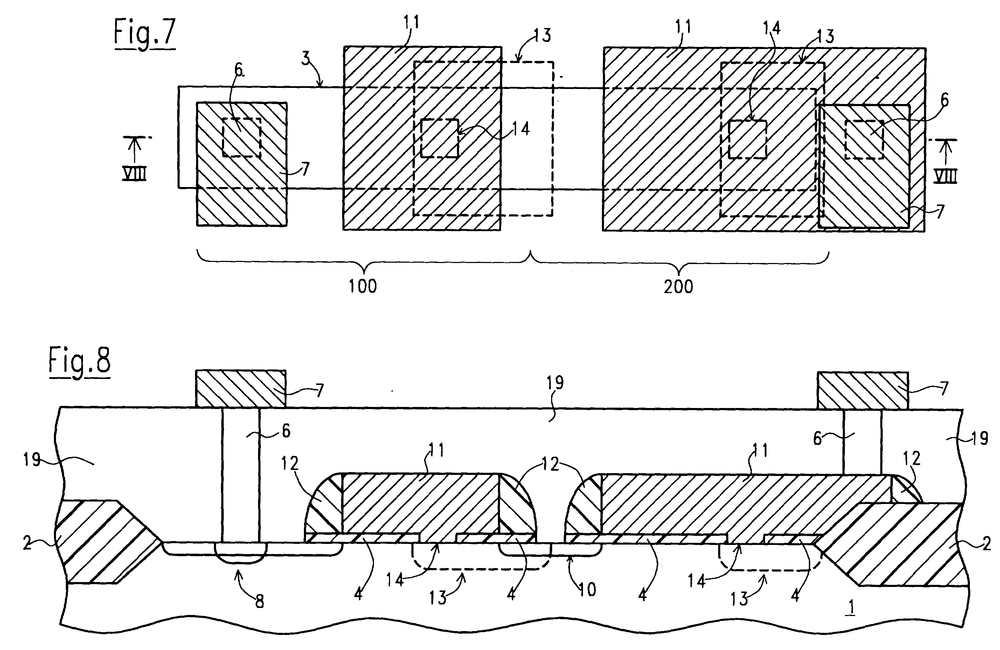

Figures 7 and 8 show a third embodiment of the present invention, wherein a contact between the drain electrode and the gate electrode of the transistor 200 is obtained by means of a direct connection between the polysilicon layer 11 and the contact 6 (such a connection is usually obtained over the field oxide 2 and consequently a larger extension of the polysilicon layer 11 is provided). The applied voltage is then transferred to the drain region 13, situated under the polysilicon layer 11 and obtained by means of a N+ implantation, through the direct contact 14.

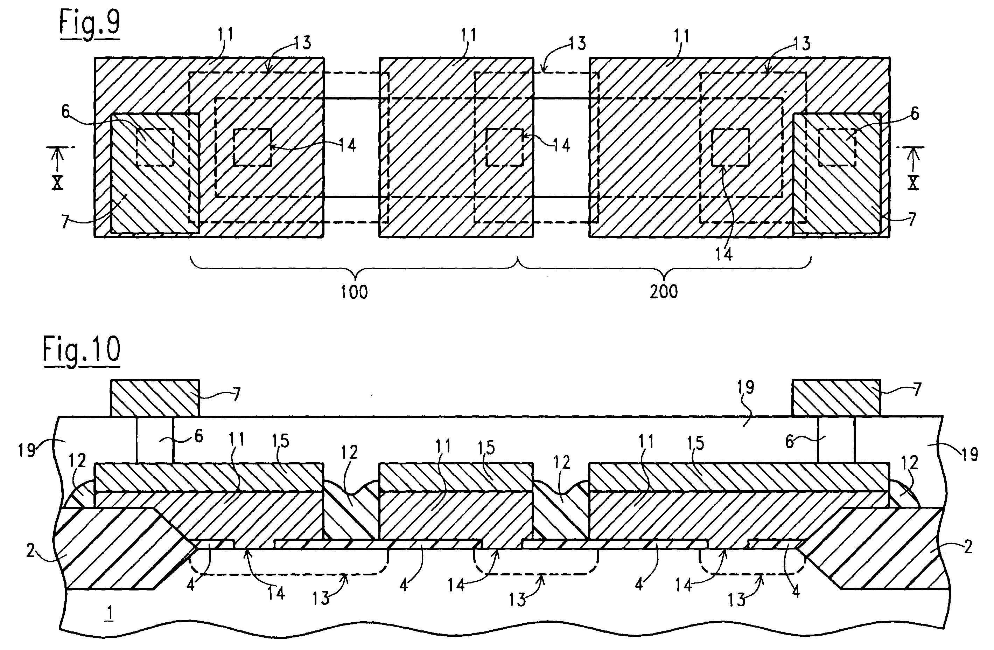

Figures 9 and 10 show a fourth embodiment of the present invention, deriving from a combination of the second and third embodiments. The distances between the polysilicon layers 11 are reduced to a minimum that can be lithographically obtained, and moreover the metal contacts are directly obtained on the polysilicon layers 11 themselves.

Such a situation turns out to be further advantageous in case that the silicon exposure of the active area regions, after the spacers 12 are formed, has to be avoided; during salicidation steps, for example, the reactions for the formation of silicide layers is obtained only on the polysilicon layers 11 (so salicide layers 15 are formed), whereas the active areas are not involved in the above-mentioned reactions, because the reagents, namely the silicon of the substrate and the metal, are physically separated from the dielectric layer forming the spacers 12. In this way a device without problems of short-circuiting to the substrate, and with a high breakdown voltage, can be obtained.

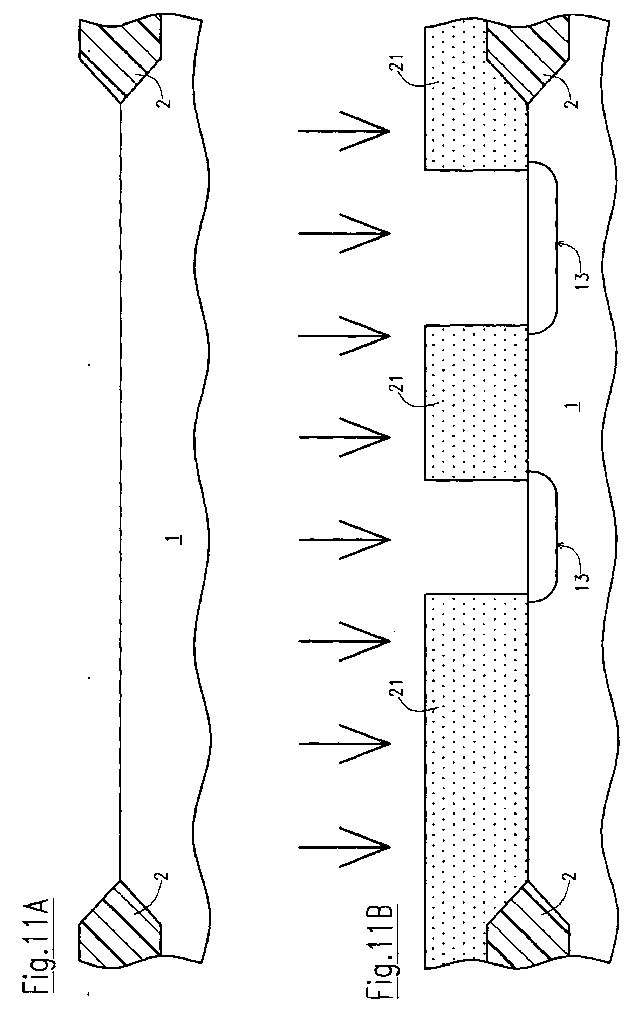

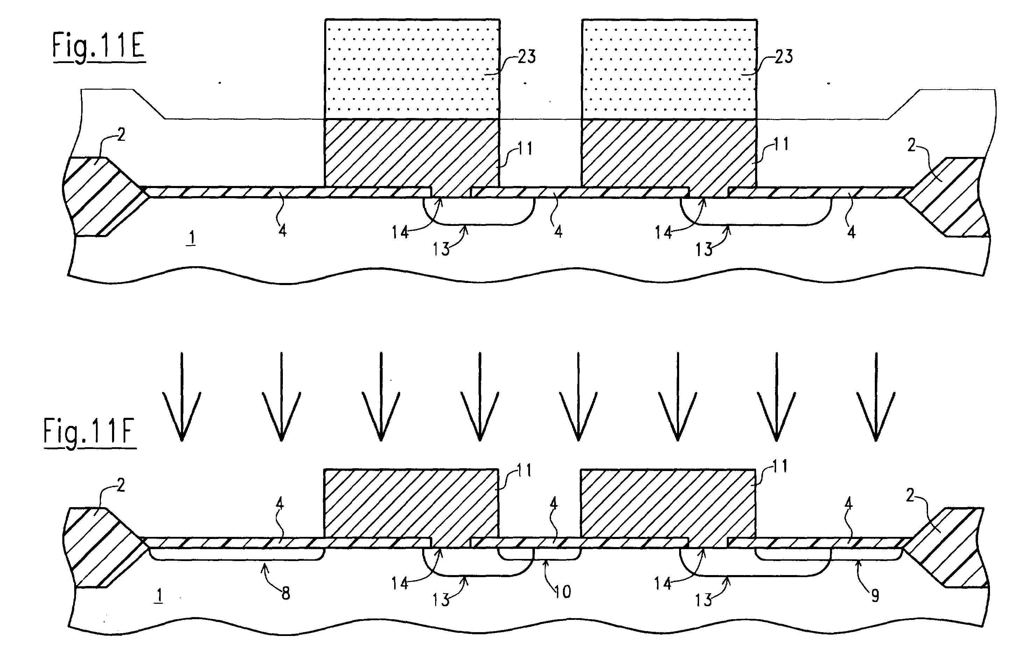

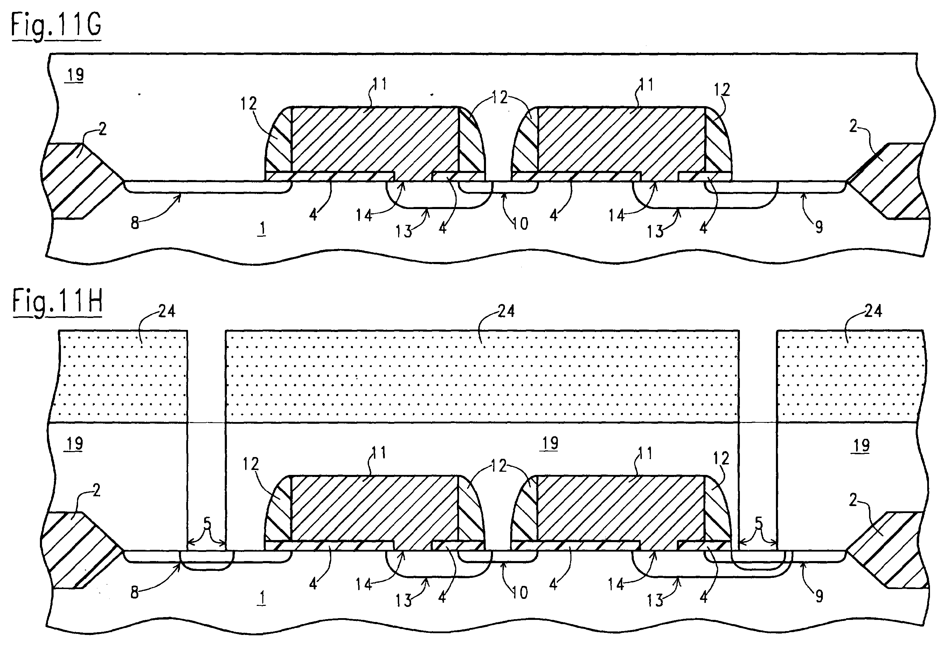

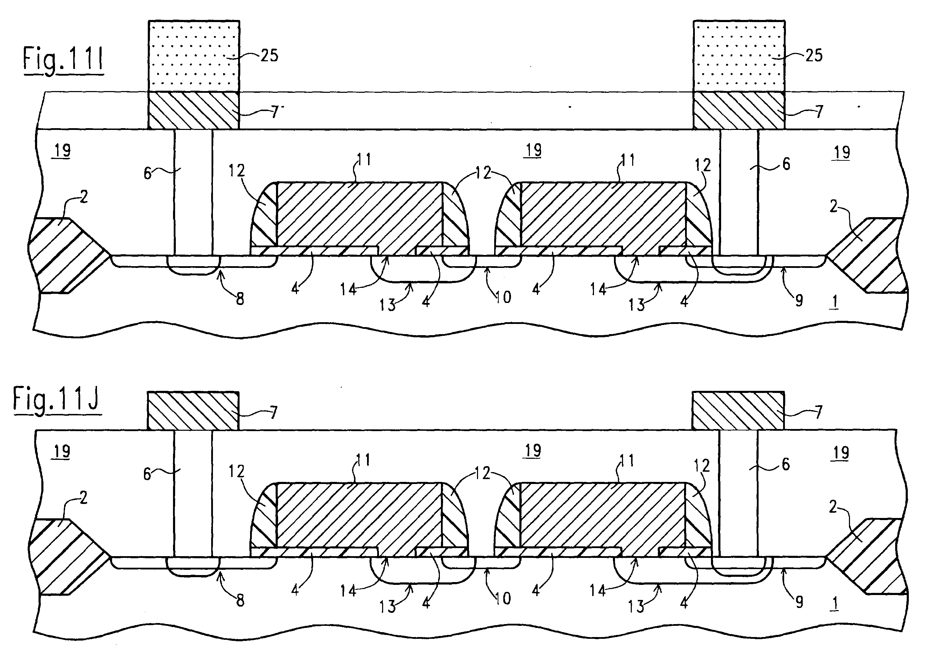

Figures 11A to 11J show schematically the main steps of a manufacturing process of two diode connected transistors according to the first embodiment of the present invention. After the first step of formation of active area regions (Fig. 11A), a first mask 21 with openings is deposited in order to allow a N+ implantation and consequently to form diffusion regions 13 (Fig. 11B). As already mentioned, in the case that the diode connected transistors have to be integrated in a EEPROM memory, it is possible to make use of the implantation already provided for the formation of the N+ regions under the tunnel oxide of the EEPROM memory cells, in order to form the doped regions 13.

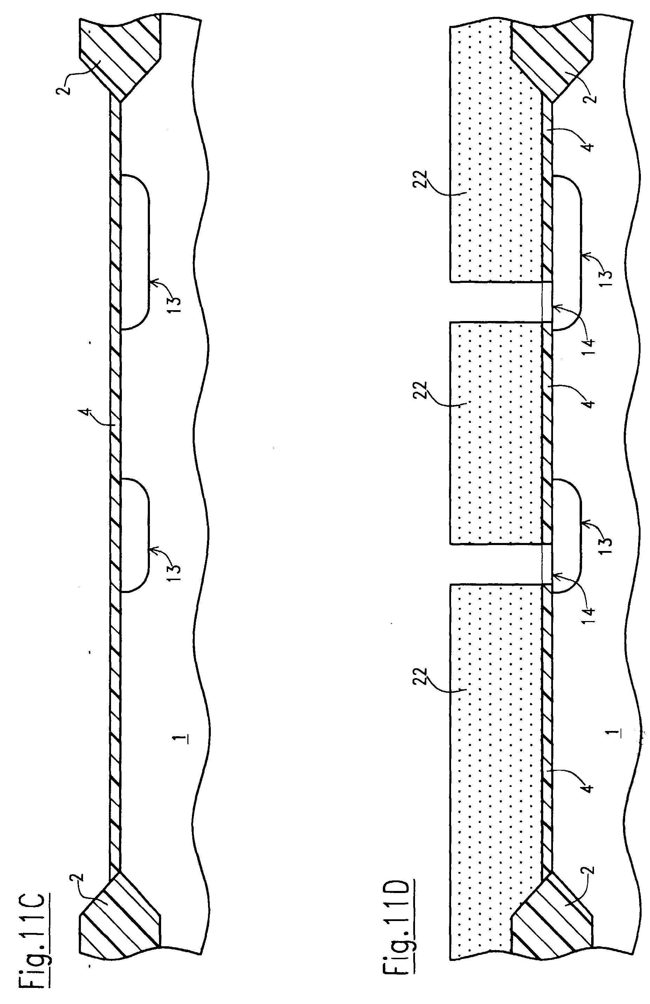

After the formation of a thin gate oxide layer 4 (Fig. 11C), a second mask 22 with openings on the diffusion regions 13 is applied in order to etch and remove portions of the gate oxide layer 4 and to form, then, the direct contact regions 14 (Fig. 11D).

At this point, the gate regions 11 are formed by means of a polysilicon layer deposition and a subsequent selective etching through a third mask 23 for photolithographic definition (Fig. 11E). A LDD implantation forms the regions 8, 9, 10 of the transistors 100 and 200 (Fig. 11F), before the spacer 12 formation at the polysilicon 11 sidewalls, and before the intermediate dielectric layer 19 deposition over all the device surface (Fig. 11G).

Subsequently, contacts are formed by means of a fourth mask 24 in order to obtain openings 5 in the intermediate dielectric layer 19 (Fig. 11H), in case adding another dopant ion implantation in the exposed regions. Then, metal interconnections 6 and 7 (Figures 11I, 11J) are formed by means of deposition of a metal layer and use of a fifth mask 25. Finally, the process continues according to the prior art, for example with the formation of possible contacts or metal lines and passivation steps.

In case of active area salicidation, the process has to be modified in order to provide for, after the spacers 12 formation step, the metal (for example titanium) deposition step, the thermally activated reaction between the deposited metal and the silicon (or polysilicon) in contact with it, and then a selective removal step of the non-reacted metal.

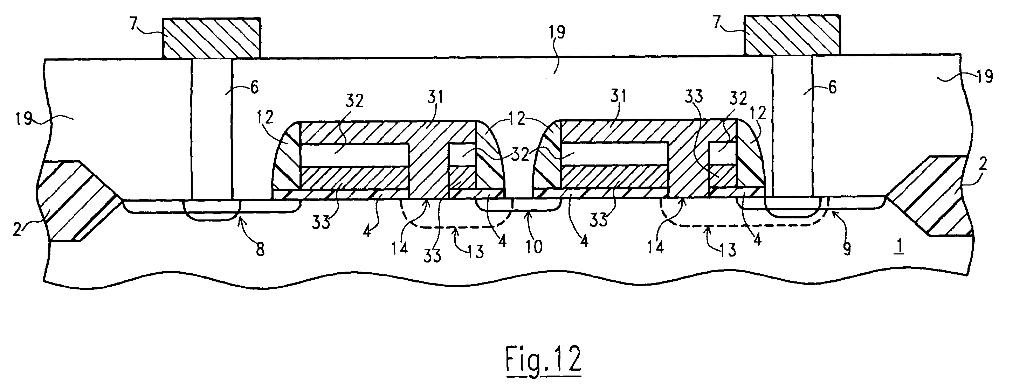

In the case that the diode connected transistors have to be integrated in a device obtained by means of a manufacturing process which provides the fabrication of two polysilicon layers (for example to obtain floating and control gates), it is necessary to modify the photolithographic masks of the process itself. Particularly, the mask for the definition of the lower polysilicon layer (which will form the floating gates) must be shaped in such a way to allow the removal of the lower polysilicon layer in the regions wherein the formation of the direct contact is desired, and, similarly, also the mask defining the intermediate dielectric comprised between the two polysilicon layers (for example ONO), must be able to allow a gate oxide etching, as well as an intermediate dielectric etching itself, in the regions wherein the direct contact has to be formed. Subsequently, the upper polysilicon layer is deposited (for control gate formation) so that it will be electrically connected to the active areas in the contact regions (as shown in Figure 12).

Thus, the main steps of a manufacturing process of an integrated semiconductor circuit comprising memory cells with double polysilicon layers, may be summarized as follows: active areas formation; implantation for the regions 13 formation; gate oxidation; lower polysilicon layer 33 deposition; lower polysilicon layer formation and selective etching (considering also the direct contact regions 14); intermediate dielectric layer 32 formation; selective etching of the above-mentioned intermediate dielectric layer (considering also the direct contact regions 14); upper polysilicon layer 31 deposition; upper polysilicon layer formation and selective etching. In this way the structure shown in Fig. 12 is obtained, wherein the upper polysilicon layers 31 are electrically connected to the doped regions 13, through openings obtained in the intermediate dielectric layers 32 and in the lower polysilicon layers 33.

Then, considering a manufacturing process of semiconductor memory devices comprising Flotox EEPROM memory cells, wherein an initial implantation is provided that must include completely the tunnel oxide region through which the Fowler-Nordheim injection is obtained, the diode connected transistors implementation according to the present invention does not provide further process expenses, neither as regards masking operations, nor further treatments.

The suggested solutions have the feature of obtaining diode connected transistors whose dimensions are defined by the distance between the N+ implantation regions and by the subsequent thermal treatments of the thermal process, that define the lateral diffusion of the N+ implantation regions themselves. The present invention is particularly suitable for semiconductor devices wherein it is necessary to integrate a speedy logic with a non-volatile memory.

It is evident that the invention extends also to diode connected P type transistor formation, instead of N type. Furthermore, the present invention extends to any number of diode connected transistors, for example a series of many diode connected transistors used to form a voltage divider.

## Claims

1. Semiconductor device comprising a semiconductor layer (1) of a first type of conductivity, a gate oxide layer (4) superimposed to said semiconductor layer (1), at least one polysilicon region (11; 31) superimposed to said gate oxide layer (4), a first (13) and a second doped region (8,10; 13) of a second type of conductivity in said semiconductor layer (1), said first (13) and second doped region (8,10; 13) being spaced-apart in order to form a channel region therebetween, under said polysilicon layer (11; 31), characterized in that said first doped region (13) extends under a contact opening (14) obtained in said gate oxide layer (4) in correspondence of said polysilicon layer (11; 31), so that said polysilicon layer (11; 31) is electrically connected with said first doped region (13) through said contact opening (14).

2. Device according to claim 1, characterized by comprising conductive elements (6,7) electrically connected with said first (13) and second doped region (8,10; 13).

3. Device according to claim 1, characterized by comprising conductive elements (6,7) electrically connected with at least one of said polysilicon regions (11; 31).

4. Device according to anyone of the preceding claims, characterized by comprising oxide spacers (12) at the sides of said polysilicon regions (11; 31).

5. Device according to anyone of claims 2 to 4, characterized in that said conductive elements (6,7) comprise contacts (6) and metal lines (7).

6. Device according to claim 5, characterized by comprising a dielectric layer (19) deposited over the upper surface of said device, said contacts (6) being inserted in it, and said metal lines (7) being placed over it.

7. Device according to anyone of the preceding claims, characterized by comprising lower polysilicon regions (33) situated between said polysilicon layers (11; 31) and said gate oxide layer (4), intermediate dielectric layers (32) placed between said polysilicon layers (11; 31) and said lower polysilicon regions (33), said lower polysilicon regions (33) and said intermediate dielectric layers (32) comprising openings for allowing the electrical connection between said polysilicon regions (11; 31) and said first doped region (13) underlying.

8. Device according to anyone of the preceding claims, characterized in that said first type of conductivity is a P type and said second type of conductivity is a N type.

9. Device according to anyone of claims 1 to 7, characterized in that said first type of conductivity is a N type and said second type of conductivity is a P type.

10. Manufacturing process of a semiconductor device according to claim 1, characterized by comprising a first step (11A) of active area regions formation, a second step (11B) of selective dopant ion implantation in said active area regions for the formation of first doped regions (13), a third step (11C) of formation of a thin gate oxide layer (4) over said active area regions, a fourth step (11D) of selective etching and subsequent removal of portions of said gate oxide layer (4) over said first doped regions (13) in order to define direct contact regions (14), a fifth step (11E) of polysilicon gate regions (11) definition, said direct contact regions (14) being fit to electrically connect said gate regions (11) with said first doped regions (13).

11. Process according to claim 10, characterized by comprising a sixth step (11E) of dopant ion implantation for second doped regions (8,9,10) formation, a seventh step (11G) of oxide spacers (12) formation at said gate regions (11) sides and of a dielectric layer (19) deposition over all the device, an eighth step (11H) of selective etching and removal of portions of said oxide layer (19), a ninth step (11I,11J) of conductive elements (6,7) definition, said conductive elements (6,7) being inserted in said oxide layer (19) spaces obtained during said eighth step (11H).
